# EUROPÄISCHE PATENTSCHRIFT

(11) **EP 3 201 954 B1**
(45) Veröffentlichungstag und Bekanntmachung des Hinweises auf die Patenterteilung: **13.02.2019**
(21) Anmeldenummer: 15770859.5
(22) Anmeldetag: 23.09.2015
(51) Int. Cl.: H01L 35/08

(54) **THERMOELEKTRISCHE VORRICHTUNG**
THERMOELECTRIC DEVICE
DISPOSITIF THERMOÉLECTRIQUE

(30) Priorität: 30.09.2014 DE 102014219855
(43) Veröffentlichungstag der Anmeldung: 09.08.2017
(73) Patentinhaber: Mahle International GmbH, 70376 Stuttgart (DE)
(72) Erfinder: ANGERMANN, Hans-Heinrich, 70567 Stuttgart (DE)
(74) Vertreter: BRP Renaud & Partner mbB Rechtsanwälte Patentanwälte Steuerberater
(86) Internationale Anmeldenummer: PCT/EP2015/071905
(87) Internationale Veröffentlichungsnummer: WO 2016/050588

(56) Entgegenhaltungen:
- DE-A1-102012 208 295
- JP-A- S59 980
- US-A- 3 249 470
- US-A- 4 855 810
- US-A- 5 441 576
- US-A1- 2006 118 159
- US-A1- 2013 152 990

## Beschreibung

Die Erfindung betrifft eine thermoelektrische Vorrichtung sowie einen thermoelektrischen Generator mit einer solchen thermoelektrischen Vorrichtung. Die Erfindung betrifft ferner ein Kraftfahrzeug mit einem solchen thermoelektrischen Generator sowie ein Verfahren zur Herstellung einer thermoelektrischen Vorrichtung.

Die Erfindung betrifft eine thermoelektrische Vorrichtung, insbesondere thermoelektrischer Generator oder Wärmepumpe, sowie ein Kraftfahrzeug mit einer solchen thermoelektrischen Vorrichtung.

Unter dem Begriff "Thermoelektrizität" versteht man die gegenseitige Beeinflussung von Temperatur und Elektrizität und ihre Umsetzung ineinander. Thermoelektrische Materialien machen sich diese Beeinflussung zunutze, um als thermoelektrische Generatoren aus Abwärme elektrische Energie zu erzeugen, kommen aber auch in Form sog. Wärmepumpen zum Einsatz, wenn unter Aufwendung von elektrischer Energie Wärme von einem Temperatur-Reservoir mit niedrigerer Temperatur in eines mit höherer Temperatur transportiert werden soll.

In Kraftfahrzeugen mit Brennkraftmaschine können thermoelektrische Generatoren die beim Verbrennungsvorgang im Abgas erzeugte Abwärme teilweise in elektrische Energie wandeln und in das elektrische Bordnetz des Kraftfahrzeugs einspeisen. Diese in elektrische Energie gewandelte Abwärme lässt sich somit nutzbar machen, um den Energieverbrauch des Kraftfahrzeugs auf ein funktionell notwendiges Mindestmaß zu senken und somit einen unnötigen Ausstoß an Abgasen wie etwa CO₂ zu vermeiden. Die Anwendungsgebiete thermoelektrischer Vorrichtungen im Fahrzeugbau sind also vielfältig. Von entscheidender Bedeutung ist es in jedem möglichen Anwendungsszenario, einen hohen Wirkungsgrad zu erzielen, um Wärme möglichst effektiv in elektrische Energie umzuwandeln oder umgekehrt. Der Einsatz in Kraftfahrzeugen führt darüber hinaus zum zusätzlichen Erfordernis, thermoelektrische Vorrichtungen in kompakter Bauweise herzustellen.

In Fahrzeugen verbaute thermoelektrische Vorrichtungen sind daher oftmals in Platten- oder Schichtbauweise hergestellt, wobei die thermoelektrisch aktiven Elemente innerhalb eines thermisch leitenden Gehäuses angeordnet werden. Das Gehäuse kann somit thermisch einerseits mit einem Temperatur-Reservoir niedriger Temperatur, der sogenannten Kaltseite, andererseits aber auch mit einem Temperatur-Reservoir mit höherer Temperatur - der Heißseite - verbunden werden, so dass die thermoelektrischen Elemente aufgrund des Temperaturgefälles zwischen beiden Seiten eine elektrische Thermospannung erzeugen, die über geeignete elektrische Anschlüsse nach außen geführt und genutzt werden kann. Je höher die Temperaturdifferenz zwischen Heiß- und Kaltseite, desto höher die von der Vorrichtung erzeugte Thermospannung.

Typischerweise umfasst eine thermoelektrische Vorrichtung mehrere thermoelektrische Elemente aus thermoelektrisch aktiven Materialien, die über geeignete elektrisch leitende Leiterbahnen im Sinne einer elektrischen Reihenschaltung miteinander verbunden sind. Eine solche elektrische Leiterbahn verbindet dabei insbesondere zwei benachbarte thermoelektrische Elemente.

Als problematisch erweist sich im Zusammenhang mit solchen Leiterbahnen typischerweise deren haftfeste Anbringung auf den thermoelektrischen Elementen, ohne dass sich im Übergangsbereich zwischen thermoelektrischen Element und Leiterbahn ein unerwünscht hoher elektrischer Widerstand ausbildet, in welchem die vom thermoelektrischen Element erzeugte elektrische Energie dissipiert wird, bevor sie nach außen abgegeben wird. Auch besteht die Gefahr, dass im Bereich der heißen Seite der thermoelektrischen Vorrichtung thermoelektrisch aktives Material in das Material der Leiterbahn und des Fügematerials eindiffundiert oder umgekehrt, so dass der Seebeck-Koeffizient des thermoelektrischen Elements in nicht unerheblichem Maße reduziert werden kann.

Vor diesem Hintergrund beschreibt die DE 10 2012 208 295 A1 ein thermoelektrisches Modul mit einem thermoelektrischen Element, welches auf einem Gehäuseelement angebracht ist. Zwischen den beiden Elementen ist ein Fügenahtbereich vorgesehen, der durch Zusammenpressen eines Fügematerials gebildet wurde. Auf dem thermoelektrischen Element kann eine Diffusionsbarriere vorgesehen werden, die ein unerwünschtes Eindringen des Fügematerials in das thermoelektrisch aktive Material des thermoelektrischen Elements verhindern soll. Die WO2011/159804 A2 offenbart eine thermoelektrische Vorrichtung mit thermoelektrisch aktiven Elementen aus einem Skutterudit. Die Vorrichtung umfasst eine als Diffusionsbarriere wirkende Schicht, die sandwichartig zwischen dem thermoelektrisch aktiven Element und einer zur elektrischen Kontaktierung vorgesehenen Metallschicht angeordnet ist. In einer Variante kann die Metallschicht auch zwischen Diffusionsbarriere und thermoelektrischem Element vorgesehen sein.

Die US 2013/0152990 A1 offenbart eine thermoelektrische Vorrichtung mit einer Adapterschicht. Die Druckschrift JP S 59 980 A schlägt vor, die Oberfläche eines thermoelektrischen Elements mittels Sandstrahlen zu polieren, um auf diese Weise einen Oxid-Film, der elektrisch isolierte Eigenschaften besitzt, wieder zu entfernen. Dies erlaubt es, eine Elektrode mit dem thermoelektrischen Element zu verlöten.

Es ist eine Aufgabe der vorliegenden Erfindung, eine verbesserte Ausführungsform einer thermoelektrischen Vorrichtung zu schaffen, bei welcher die oben beschriebene Problematik nicht mehr auftritt.

Diese Aufgabe wird durch den Gegenstand der unabhängigen Patentansprüche gelöst. Bevorzugte Ausführungsformen sind Gegenstand der abhängigen Patentansprüche.

Grundgedanke der Erfindung ist demnach, thermoelektrisch aktive Elemente einer thermoelektrischen Vorrichtung - im Folgenden sollen diese vereinfacht als "thermoelektrische Elemente" bezeichnet werden - in spezieller Weise zu metallisieren, d.h. mit wenigstens einer Adapterschicht aus einem Metall auszustatten, die auf einer Oberfläche des jeweiligen thermoelektrischen Elements vorgesehen wird. Somit kann auf der Adapterschicht eine elektrisch leitende Leiterbahn aufgebracht werden, die im Sinne einer elektrischen Reihenschaltung zum elektrischen Verbinden zweier benachbarter thermoelektrischer Elemente dient. Die Bereitstellung einer derartigen, metallischen Adapterschicht begünstigt eine zuverlässige mechanische Haftung der elektrisch leitenden Leiterbahnen - im Folgenden als Leiterbahn-Elemente bezeichnet - auf dem thermoelektrischen Element. Darüber hinaus besitzt eine solche Metallschicht zusätzlich die Eigenschaften einer vorteilhaften Diffusionsbarriere. Schließlich wird mit Hilfe der hier vorgestellten Adapterschicht ein für die thermoelektrischen Eigenschaften der gesamten Vorrichtung vorteilhafter, geringer elektrischer Widerstand im Übergangsbereich zwischen thermoelektrischem Element und Leiterbahn-Element erzielt.

Ein besonders geringer elektrischer Widerstand in besagtem Übergangsbereich lässt sich erreichen, indem für das Metall der Adapterschicht ein Material mit möglichst geringem spezifischem elektrischem Widerstand gewählt wird. Experimentelle Untersuchungen haben gezeigt, dass die thermoelektrischen Eigenschaften der thermoelektrischen Vorrichtung nicht oder nur in unerheblichem Maße eingeschränkt werden, wenn das Metall der Adapterschicht einen spezifischen Widerstand aufweist, der weniger als 0,9 Ωcm, vorzugsweise weniger als 0,2 Ωcm, höchst vorzugsweise weniger als 0,03 Ωcm, beträgt.

Derartig niedrige spezifische elektrische Widerstände lassen sich erzielen, wenn Metalle mit niedrigem oder überhaupt keinem Legierungsgehalt verwendet werden. Besonders gute Ergebnisse hinsichtlich der geforderten hohen elektrischen Leitfähigkeit werden dabei erreicht, wenn durch geeignete Materialwahl sichergestellt wird, dass das Metall der Adapterschicht einen Legierungsgehalt von weniger als 10 Gew-%, vorzugsweise von weniger als 5 Gew-%, höchst vorzugsweise von weniger als 2 Gew-%, aufweist.

Als besonders geeignete Materialien für die Adapterschicht aus Metall kommen Silber und Kupfer in Betracht, da diese einen elektrischen Widerstand von nur 0,016 Ωcm bzw. 0,017 Ωcm besitzen. Die Verwendung von Silber ist zwar gegenüber der Verwendung von Kupfer üblicherweise mit deutlich erhöhten Beschaffungskosten verbunden. Silber erweist sich jedoch im Vergleich zu Kupfer als besonders oxidationsbeständig. Daher können auf Silber Leiterbahn-Elemente ohne Verwendung eines Flussmittels aufgebracht werden.

Besonders zweckmäßig kann die Adapterschicht aus einer Silberschicht oder einer Kupferschicht besteht, d.h. in einem solchen Szenario sind - abgesehen von Verunreinigungen in Form von Fremdatomen vernachlässigbarer Anzahl - außer Silber bzw. Kupfer keine weiteren Substanzen in der Adapterschicht enthalten. Für die Bereitstellung einer Adapterschicht mit guten Hafteigenschaften empfiehlt sich die Verwendung eines Spritzverfahrens zum Auftragen der Adapterschicht auf den jeweiligen betroffenen thermoelektrischen Elementen. Dabei ist es vorteilhaft, wenn die thermoelektrischen Elemente eine Rauheit aufweisen, in die sich die Spritzschicht beim Abkühlen "verkrallen" kann. Erfindungsgemäß wird eine solche Rauheit mittels eines Schleifverfahrens aufgebracht. Wesentliches Kennzeichen einer solchen, gespritzten Adapterschicht ist die mittels des Spritzverfahrens erzielte Rauigkeit. Auf einer derartig rauen Adapterschicht kann sich ein Fügematerial, mittels welchem die elektrische Leiterbahn mit dem thermoelektrischen Element gefügt wird, ebenfalls mechanisch gut "verkrallen".

Erhebliche Kostenvorteile bei der Herstellung der Adapterschicht lassen sich erzielen, wenn die neue Schicht aus mindestens zwei Schichten aufgebaut wird, und zwar zunächst aus einer gespritzten Schicht aus einem kostengünstigen Werkstoff wie z.B. Kupfer, Nickel, Eisen oder Titan, wodurch die Rauigkeit der Adapterschicht gewährleistet ist, und aus mindestens einer zweiten, dünnen Schicht aus Silber oder Kupfer, Diese zweite Schicht wird nicht durch Spritzen, sondern durch ein PVD-Verfahren oder durch Galvanisieren, insbesondere durch Tampon-Galvanisieren appliziert. Eine Schichtdicke der zweiten, dünnen Schicht sollte vorzugsweise weniger als 10 µm betragen. Auf einer zweiten dünnen und damit kostengünstigen Schicht, die Silber umfasst, kann dann ein Leiterbahn-Element ohne Verwendung eines Flussmittels aufgebracht werden.

Als besonders geeigneter Bestandteil von Materialsystemen für das thermoelektrisch aktive Material der thermoelektrischen Elemente erweist sich Antimon (Sb), welches sich durch eine besonders ausgeprägte thermoelektrische Aktivität auszeichnet.

Die Erfindung betrifft ferner einen thermoelektrischen Generator, insbesondere für ein Kraftfahrzeug, mit wenigstens einer thermoelektrischen Vorrichtung mit einem oder mehreren der vorangehend genannten Merkmale.

Die Erfindung betrifft weiterhin auch ein Kraftfahrzeug mit wenigstens einer Energieversorgungseinheit, insbesondere einer wiederaufladbaren Batterie, und dem vorangehend vorgestellten thermoelektrischen Generator.

Die Erfindung betrifft schließlich ein Verfahren zum Herstellen einer thermoelektrischen Vorrichtung, insbesondere einer thermoelektrischen Vorrichtung mit einem oder mehreren der vorangehend diskutierten Merkmale. Das Verfahren umfasst einen ersten Schritt a), gemäß welchem wenigstens zwei, insbesondere benachbart und im Abstand zueinander angeordnete, thermoelektrische Elemente aus einem thermoelektrisch aktiven Material bereitgestellt werden. Ausdrücklich umfasst sind vom hier vorgestellten Verfahren also Vorrichtungen mit mehr als zwei thermoelektrischen Elementen.

Hierzu wird in einem dem Schritt a) nachgeschalteten Schritt a1) die Oberfläche des thermoelektrisch aktiven Materials der thermoelektrischen Elemente mittels eines Schleifverfahrens aufgeraut.

Auf jedes thermoelektrische Element wird in einem zweiten Schritt b) eine Adapterschicht aus einem Metall aufgebracht. Typischerweise mag das Aufbringen einer solchen Adapterschicht auf zwei verschiedenen, vorzugsweise auf zwei einander gegenüberliegenden Seiten eines jeden thermoelektrischen Elements erfolgen, so dass die beiden Seiten für eine elektrische Verbindung mit benachbarten thermoelektrischen Elemente herangezogen werden können. Dies kann unter Anwendung eines dem Fachmann geläufigen Fügeprozesses wie beispielsweise einem Lötprozess oder einem Sinterprozess, in letzterem Fall insbesondere mittels Silbersintern oder Spark-Plasma-Sintern, erfolgen.

Hierzu wird in einem weiteren Schritt c) des Verfahrens ein jeweiliges Leiterbahn-Element auf die Adapterschichten aufgebracht, und zwar derart, dass es benachbart angeordnete thermoelektrische Elemente elektrisch miteinander verbindet. Für den praxisüblichen Fall, dass eine Mehrzahl von thermoelektrischen Elementen nebeneinander angeordnet ist, kann ein bestimmtes thermoelektrisches Element über eine erste Leiterbrücke, die auf einer ersten Adapterschicht aufgebracht ist, mit einem in der Erstreckungsrichtung benachbarten ersten thermoelektrischen Element verbunden werden. In analoger Weise wird dann dasselbe thermoelektrische Element über eine zweite Leiterbrücke, die auf einer der ersten gegenüberliegenden, zweiten Adapterschicht aufgebracht ist, mit einem entgegen der Erstreckungsrichtung benachbarten, zweiten thermoelektrischen Element verbunden. Dies ermöglicht eine platzsparende, "kettenartige" Anordnung einer grundsätzlich beliebigen Anzahl von thermoelektrischen Elementen.

Kostenvorteile bei der Herstellung der thermoelektrischen Vorrichtung, ohne dass dies mit Einbußen in der Haftfestigkeit der Adapterschicht auf den thermoelektrischen Elementen bzw. der Haftfestigkeit des Fügematerials auf der Adapterschicht verbunden wäre, lassen sich erzielen, wenn das Aufbringen der Adapterschicht gemäß Schritt b) mittels eines Spritzverfahrens, insbesondere mittels Drahtspritzen oder mittels Kaltgasspritzen, erfolgt. Bei letzterem muss das metallische Beschichtungspulver nur auf eine Temperatur von einigen wenigen 100°C erhitzt werden, so dass beim dem Aufheizen nachfolgenden Abkühlungsvorgang in allenfalls vernachlässigbar kleinen Maße thermische bedingte mechanische Spannungen - aufgrund der Temperaturdifferenz zwischen Beschichtungspulver und zu beschichtender Oberfläche - auftreten.

Besonders gute Hafteigenschaften der zu beschichtenden Oberflächen der thermoelektrischen Elemente ergeben sich, wenn das Verfahren um den folgenden Schritt a) nachgeschalteten Schritt a1) ergänzt wird:
a1) Aufrauen der Oberfläche des thermoelektrischen Materials mittels eines Strahlverfahrens, insbesondere mittels eines Sandstrahlverfahrens, oder mittels Schleifen auf einem an die gewünschte Zielrauigkeit angepassten Schleifmedium.

Weitere wichtige Merkmale und Vorteile der Erfindung ergeben sich aus den Unteransprüchen, aus der Zeichnung und aus der zugehörigen Figurenbeschreibung anhand der Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in der Zeichnung dargestellt und werden in der nachfolgenden Beschreibung näher erläutert, wobei sich gleiche Bezugszeichen auf gleiche oder ähnliche oder funktional gleiche Komponenten beziehen.

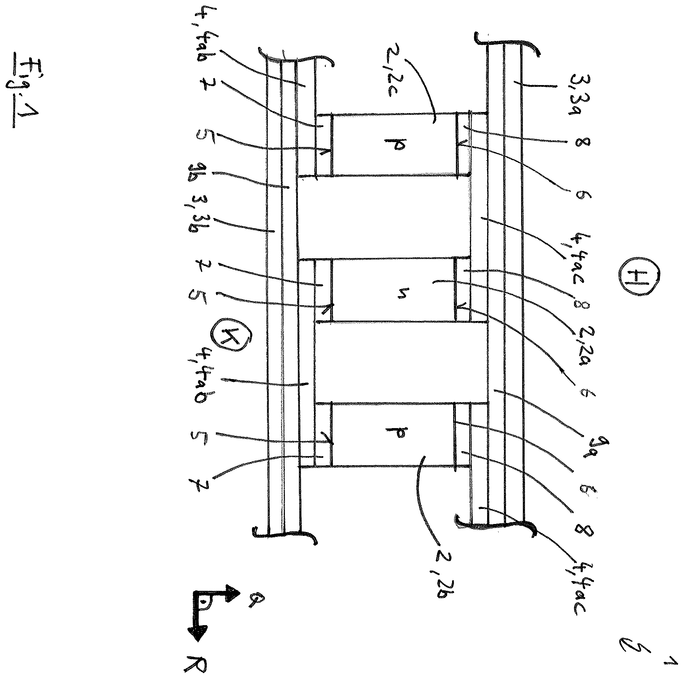

Die einzige Figur 1 zeigt eine thermoelektrische Vorrichtung 1, beispielsweise für einen thermoelektrischen Generator. Diese besitzt eine Mehrzahl entlang einer Erstreckungsrichtung R benachbart und im Abstand zueinander angeordneter thermoelektrischer Elemente 2. Im Beispielszenario der Figur 1 sind der Übersichtlichkeit halber nur drei solche Elemente 2a, 2b, 2c dargestellt, welche jeweils abwechselnd ein dem einschlägigen Fachmann vertrautes thermoelektrisches p-bzw. n-Material aufweisen, welches beispielsweise Antimon (Sb) enthält.

Die thermoelektrische Vorrichtung 1 kann mit einem Gehäuse 3 aus einem Metall ausgestattet sein. In Figur 1 ist das Gehäuse 3 nur teilweise und schematisch in Form zweier gegenüberliegender Gehäusewände 3a, 3b gezeigt, welche thermisch mit der Heißseite H bzw. der Kaltseite K des Generators gekoppelt werden können. Zwischen den thermoelektrischen Elementen 2 und den beiden einander gegenüberliegenden Gehäusewänden 3a, 3b ist im Beispiel der Figur 1 jeweils eine elektrisch isolierende Schicht 9a, 9b vorgesehen, um die thermoelektrischen Elemente 2 elektrisch gegenüber dem metallischen Gehäuse 3 zu isolieren. Die elektrisch isolierenden Schichten 9a, 9b mögen dabei etwa aus einer Keramik oder einem anderen geeigneten, elektrisch isolierenden Material mit hoher Wärmeleitfähigkeit hergestellt sein.

Jedes thermoelektrische Element 2 weist entlang einer quer zur Erstreckungsrichtung R verlaufenden Querrichtung Q eine erste Seite 5 und eine dieser gegenüberliegenden zweiten Seite 6 auf. Jedes der thermoelektrischen Elemente 2 ist ferner mittels wenigstens eines Leiterbahn-Elements 4 mit einem benachbarten thermoelektrischen Element 2 verbunden. Die Leiterbahn-Elemente 4 können aus einem Metall mit einem möglichst geringen spezifischen elektrischen Widerstand hergestellt sein. In Betracht kommen dafür insbesondere Kupfer, Nickel, oder Eisen.

Für den Fall, dass ein bestimmtes thermoelektrisches Element 2 - in Figur 1 ist dies das bezüglich der Erstreckungsrichtung R mittlere Element 2a - sowohl in als auch entgegen der Erstreckungsrichtung R einen Nachbarn 2b bzw. 2c besitzt, dient ein erstes Leiterbahn-Element 4ab, das auf der ersten Seite 5 der thermoelektrischen Elemente 2 angeordnet ist, zur elektrischen Verbindung des bestimmten thermoelektrischen Elements 2a mit seinem Nachbarn 2b in Erstreckungsrichtung R. Ein weiteres, zweites Leiterbahn-Element 4ac, das auf der zweiten Seite 6 der thermoelektrischen Elemente 2 angeordnet ist, dient entsprechend zur elektrischen Verbindung des Elements 2a mit seinem Nachbarn 2c. Die einzelnen thermoelektrischen Elemente 2a, 2b, 2c werden auf diese Weise mit Hilfe der Leiterbahn-Elemente 4ab, 4ac im Sinne einer elektrischen Reihenschaltung elektrisch miteinander verbunden. Das erste Leiterbahn-Element 4ab verbindet dabei wie in Figur 1 gezeigt die beiden ersten Seiten 5 der beiden thermoelektrischen Elemente 2a, 2b, das zweite Leiterbahn-Element 4ac die beiden zweiten Seiten 6 der beiden thermoelektrischen Elemente 2a, 2c.

Auf den thermoelektrischen Elementen 2a, 2b, 2c ist sowohl auf der ersten Seite 5 als auch auf der zweiten Seite 6 jeweils eine Adapterschicht 7, 8 aus einem Metall vorgesehen, die sandwichartig zwischen dem jeweiligen thermoelektrischen Element 2a, 2b, 2c und dem jeweiligen Leiterbahn-Element 4ab, 4ac angeordnet ist. Im Beispiel der Figur 1 umfasst oder ist das Metall der Adapterschicht Silber oder Kupfer. Ersteres besitzt einen spezifischen elektrischen Widerstand von 0,016 Ωcm, letzteres von 0,017 Ωcm. Silber erweist sich dabei als besonders oxidationsbeständig. Auf Silber lassen sich darüber hinaus auf vorteilhafte Weise ohne Verwendung eines Flussmittels die elektrischen Leiterbahn-Elemente 4, 4ab, 4ac aufbringen. Besonders zweckmäßig kann die Adapterschicht aus einer reinen Silberschicht oder einer reinen Kupferschicht bestehen. Dann sind - abgesehen von Verunreinigungen in Form von Fremdatomen vernachlässigbarer Zahl - außer Silber bzw. Kupfer keine weiteren Substanzen in der Adapterschicht enthalten. In Varianten des Beispiels kommen aber auch andere Metalle in Betracht, die einen spezifischen Widerstand aufweisen, der weniger als 0,9 Ωcm, vorzugsweise weniger als 0,2 Ωcm, höchst vorzugsweise weniger als 0,03 Ωcm, beträgt. Derartige Widerstandswerte lassen sich beispielsweise erzielen, indem Metalle mit niedrigem oder überhaupt keinem Legierungsgehalt verwendet werden. Zu denken ist etwa an einen Legierungsgehalt von weniger als 10 Gew-%, vorzugsweise von weniger als 5 Gew-%, höchst vorzugsweise von weniger als 2 Gew-%.

Zum Aufbringen der Adapterschichten 7, 8 auf die thermoelektrischen Elemente 2, 2a, 2b, 2c mit guten Hafteigenschaften empfiehlt sich die Verwendung eines Spritzverfahrens, beispielsweise Drahtspritzen oder Kaltspritzen. Beim Kaltspritzen muss das metallische Beschichtungspulver nur auf wenige 100°C erhitzt werden, so dass beim auf das Aufheizen folgenden Abkühlungsvorgang nur in vernachlässigbar geringem Maße thermische Spannungen, verursacht durch die Temperaturdifferenz zwischen Beschichtungspulver und zu beschichtender Oberfläche, auftreten.

Vor dem Aufbringen der Adapterschichten 7,8 werden die jeweiligen ersten bzw. zweiten Seiten 5, 6 der thermoelektrischen Elemente 2, 2a, 2b, 2c mittels eines Schleifverfahrens aufgeraut.

In die aufgespritzten und aufgerauten Adapterschichten 7, 8 kann sich ein in einem nachfolgenden Schritt aufgebrachtes Fügematerial gut mechanisch verkrallen. Es versteht sich, dass nicht die gesamte Adapterschichten 7, 8 aus Silber bestehen müssen, sondern dass die gewünschte Rauigkeit der gesamten Adapterschicht 7, 8 auch durch eine erste aufgespritzte Schicht aus einem gegenüber Silber kostengünstigeren Werkstoff wie etwa Nickel, Kupfer, Eisen oder Titan- mit niedrigem spezifischen elektrischen Widerstand erzielt wird, auf die dann eine zweite dünne Schicht, z.B. aus Silber oder auch aus Kupfer, etwa mittels PVD, galvanisch oder tampon-galvanisch aufgebracht wird.

## Patentansprüche

1. Thermoelektrische Vorrichtung (1), insbesondere für einen thermoelektrischen Generator,
- mit wenigstens zwei thermoelektrischen Elementen (2, 2a, 2b, 2c), die aus einem thermoelektrisch aktiven Material hergestellt sind und mittels eines Schleifverfahrens aufgeraut sind,
- mit wenigstens einem die thermoelektrischen Elemente (2, 2a, 2b, 2c) elektrisch verbindenden Leiterbahn-Element (4, 4ab, 4ac),
- mit einer auf dem jeweiligen thermoelektrischen Element (2, 2a, 2b, 2c) angeordneten Adapterschicht (7, 8) aus einem Metall, die sandwichartig zwischen dem jeweiligen thermoelektrischen Element (2, 2a, 2b, 2c) und dem Leiterbahn-Element (4, 4ab, 4ac) vorgesehen ist.

2. Thermoelektrische Vorrichtung nach Anspruch 1,
**dadurch gekennzeichnet, dass**
das Metall der Adapterschicht (7, 8) einen spezifischen Widerstand aufweist, der weniger als 0,9 Ωcm, vorzugsweise weniger als 0,2 Ωcm, höchst vorzugsweise weniger als 0,03 Ωcm, beträgt.

3. Thermoelektrische Vorrichtung nach Anspruch 1 oder 2,
**dadurch gekennzeichnet, dass**
das Metall der Adapterschicht (7, 8) einen Legierungsgehalt von weniger als 10 Gew-%, vorzugsweise von weniger als 5 Gew-%, höchst vorzugsweise von weniger als 2 Gew-%, aufweist.

4. Thermoelektrische Vorrichtung einem der Ansprüche 1 bis 3,
**dadurch gekennzeichnet, dass**
das Metall der Adapterschicht (7, 8) Silber oder Kupfer umfasst.

5. Thermoelektrische Vorrichtung nach einem der vorhergehenden Ansprüche, **dadurch gekennzeichnet, dass**
die Adapterschicht (7, 8) aus einer Silberschicht oder einer Kupferschicht besteht.

6. Thermoelektrische Vorrichtung nach einem der vorhergehenden Ansprüche, **dadurch gekennzeichnet, dass**
die Adapterschicht (7,8) mindestens zwei Schichten umfasst, von welchen mindestens eine durch thermisches Spritzen auf das jeweilige thermoelektrische Element (2, 2a, 2b, 2c) aufgebracht ist.

7. Thermoelektrische Vorrichtung nach Anspruch 6,
**dadurch gekennzeichnet, dass**
eine erste Schicht der Adapterschicht (7, 8) ein metallisches Material mit niedrigem spezifischem elektrischen Widerstand, insbesondere Kupfer, Nickel, Eisen oder Titan, umfasst und mittels eines thermischen Spritzverfahren aufgebracht ist.

8. Thermoelektrische Vorrichtung nach Anspruch 6 oder 7,
**dadurch gekennzeichnet, dass** die
- zweite Schicht der Adapterschicht (7, 8) Kupfer oder Silber umfasst,
- eine Schichtdicke von weniger als 10 µm aufweist,
- auf die erste Schicht mittels physikalischer Gasphasenabscheidung (PVD) oder mittels eines galvanischen Prozesses aufgebracht ist.

9. Thermoelektrische Vorrichtung nach einem der vorhergehenden Ansprüche,
**dadurch gekennzeichnet, dass**
die Adapterschicht (7, 8) an die wenigstens zwei thermoelektrischen Elemente (2, 2a, 2b, 2c) angespritzt ist.

10. Thermoelektrische Vorrichtung nach einem der vorhergehenden Ansprüche,
**dadurch gekennzeichnet, dass**
das thermoelektrisch aktive Material Antimon (Sb) umfasst.

11. Thermoelektrischer Generator, insbesondere für ein Kraftfahrzeug,
mit wenigstens einer thermoelektrischen Vorrichtung (1) nach einem der vorhergehenden Ansprüche.

12. Kraftfahrzeug mit wenigstens einer Energieversorgungseinheit, insbesondere einer wiederaufladbaren Batterie, und einem thermoelektrischen Generator nach Anspruch 11.

13. Verfahren zum Herstellen einer thermoelektrischen Vorrichtung (1), insbesondere nach einem der Ansprüche 1 bis 10,
umfassend die folgenden Schritte:
a) Bereitstellen wenigstens zweier thermoelektrischer Elemente (2, 2a, 2b, 2c) aus einem thermoelektrisch aktiven Material,
b) Aufbringen einer Adapterschicht (7, 8) aus einem Metall auf die zwei thermoelektrischen Elemente (2, 2a, 2b, 2c),
c) Aufbringen eines Leiterbahn-Elements (4, 4ab, 4ac) auf die Adapterschichten (7, 8), derart dass es die thermoelektrischen Elemente (2, 2a, 2b, 2c) elektrisch miteinander verbindet,
**dadurch gekennzeichnet, dass**
das Verfahren folgenden, dem Schritt a) nachgeschalteten Schritt a1) umfasst:
a1) Aufrauen der Oberfläche des thermoelektrisch aktiven Materials der thermoelektrischen Elemente (2, 2a, 2b, 2c) mittels eines Schleifverfahrens.

14. Verfahren nach Anspruch 13,
**dadurch gekennzeichnet, dass**
das Aufbringen gemäß Schritt b) mittels Spritzverfahrens, insbesondere mittels Drahtspritzen oder mittels Kaltgasspritzen, erfolgt.

## Claims

1. Thermoelectric device (1), in particular for a thermoelectric generator,
- comprising at least two thermoelectric elements (2, 2a, 2b, 2c) which are made of a thermoelectrically active material and are roughened by means of a grinding process,
- comprising at least one conductor path element (4, 4ab, 4ac) that electrically connects the thermoelectric elements (2, 2a, 2b, 2c),
- comprising an adapter layer (7, 8) which is made of a metal and arranged on each thermoelectric element (2, 2a, 2b, 2c), and is sandwiched between the respective thermoelectric element (2, 2a, 2b, 2c) and the conductor path element (4, 4ab, 4ac).

2. Thermoelectric device according to claim 1,
**characterised in that**
the metal of the adapter layer (7, 8) has a specific resistance which is less than 0.9 Ωcm, preferably less than 0.2 Ωcm, most preferably left than 0.03 Ωcm.

3. Thermoelectric device according to claim 1 or 2,
**characterised in that**
the metal of the adapter layer (7, 8) has an alloy content of less than 10 wt%, preferably less than 5 wt%, most preferably less than 2 wt%.

4. Thermoelectric device according to any one of claims 1 to 3,
**characterised in that**
the metal of the adapter layer (7, 8) comprises silver or copper.

5. Thermoelectric device according to any one of the preceding claims,
**characterised in that**
the adapter layer (7, 8) consists of a silver layer or a copper layer.

6. Thermoelectric device according to any one of the preceding claims,
**characterised in that**
the adapter layer (7, 8) comprises at least two layers, of which at least one is applied by thermal spraying on to the respective thermoelectric element (2, 2a, 2b, 2c).

7. Thermoelectric device according to claim 6,
**characterised in that**
a first layer of the adapter layer (7, 8) comprises a metal material with low specific electrical resistance, in particular copper, nickel, iron or titanium, and is applied by means of a thermal spraying process.

8. Thermoelectric device according to claim 6 or 7,
**characterised in that** the
- second layer of the adapter layer (7, 8) comprises copper or silver,
- has a layer thickness of less than 10 µm,
- is applied onto the first layer by means of physical vapour deposition (PVD) or by means of a galvanic process.

9. Thermoelectric device according to any one of the preceding claims,
**characterised in that**
the adapter layer (7, 8) is injection moulded onto the at least two thermoelectric elements (2, 2a, 2b, 2c).

10. Thermoelectric device according to any one of the preceding claims,
**characterised in that**
the thermoelectric active material comprises antimony (Sb).

11. Thermoelectric generator, in particular for a motor vehicle,
comprising at least one thermoelectric device (1) according to any one of the preceding claims.

12. Motor vehicle with at least one energy supply unit, in particular a rechargeable battery, and a thermoelectric generator according to claim 11.

13. Method for producing a thermoelectric device (1), in particular according to any one of claims 1 to 10,
comprising the following steps:
a) providing at least two thermoelectric elements (2, 2a, 2b, 2c) made from a thermoelectric active material,
b) applying an adapter layer (7, 8) made of a metal onto the two thermoelectric elements (2, 2a, 2b, 2c),
c) applying a conductor path element (4, 4ab, 4ac) on the adapter layers (7, 8), such that it electrically connects the thermoelectric elements (2, 2a, 2b, 2c) with each other,
**characterised in that**
following the method, step a1) following the step a) comprises:
a1) roughening the surface of the thermoelectric active material of the thermoelectric elements (2, 2a, 2b, 2c) by means of a grinding procedure.

14. Method according to claim 13,
**characterised in that**
the application according to step b) is carried out by means of spraying process, in particular by means of wire spraying or by means of cold gas spraying.

## Revendications

1. Dispositif thermoélectrique (1), notamment pour générateur thermoélectrique,
- avec au moins deux éléments thermoélectriques (2, 2a, 2b, 2c) constitués d'un matériau thermoélectriquement actif et rendu rugueux par un procédé de meulage,
- avec au moins un élément de piste conductrice (4, 4ab, 4ac) reliant électriquement les éléments thermoélectriques (2, 2a, 2b, 2c),
- avec une couche d'adaptateur (7, 8) en métal agencée sur l'élément thermoélectrique (2, 2a, 2b, 2c) respectif, qui est enserrée entre l'élément thermoélectrique (2, 2a, 2b, 2c) respectif et l'élément de piste conductrice (4, 4ab, 4ac).

2. Dispositif thermoélectrique selon la revendication 1,
**caractérisé en ce que** le métal de la couche d'adaptateur (7, 8) présente une résistivité spécifique, qui est inférieure à 0,9 Ωcm, de préférence inférieure à 0,2 Ωcm, de la manière la plus préférée inférieure à 0,03 Ωcm.

3. Dispositif thermoélectrique selon la revendication 1 ou 2,
**caractérisé en ce que**
le métal de la couche d'adaptateur (7, 8) a une teneur en alliage inférieure à 10 % en poids, de préférence inférieure à 5 % en poids, de la manière la plus préférée inférieure à 2 % en poids.

4. Dispositif thermoélectrique selon l'une quelconque des revendications 1 à 3, **caractérisé en ce que**
le métal de la couche d'adaptateur (7, 8) est de l'argent ou du cuivre.

5. Dispositif thermoélectrique selon l'une quelconque des revendications précédentes,
**caractérisé en ce que**
la couche d'adaptateur (7, 8) est constituée d'une couche d'argent ou d'une couche de cuivre.

6. Dispositif thermoélectrique selon l'une quelconque des revendications précédentes,
**caractérisé en ce que**
la couche d'adaptateur (7, 8) comprend au moins deux couches, dont l'une au moins est appliquée par pulvérisation thermique sur l'élément thermoélectrique (2, 2a, 2b, 2c) respectif.

7. Dispositif thermoélectrique selon la revendication 6,
**caractérisé en ce que**
une première couche de la couche d'adaptateur (7, 8) comporte un matériau métallique à faible résistivité électrique spécifique, en particulier du cuivre, du nickel, du fer ou du titane, et est appliquée au moyen d'un procédé de pulvérisation thermique.

8. Dispositif thermoélectrique selon la revendication 6 ou 7,
**caractérisé en ce que**
- la seconde couche de la couche d'adaptateur (7, 8) comprend du cuivre ou de l'argent,
- présente une épaisseur de couche inférieure à 10 µm,
- est appliquée sur la première couche au moyen d'un dépôt physique en phase vapeur (PVD) ou au moyen d'un procédé galvanique.

9. Dispositif thermoélectrique selon l'une quelconque des revendications précédentes,
**caractérisé en ce que**
la couche d'adaptateur (7, 8) est pulvérisée sur les au moins deux éléments thermoélectriques (2, 2a, 2b, 2c).

10. Dispositif thermoélectrique selon l'une quelconque des revendications précédentes,
**caractérisé en ce que**
le matériau thermoélectriquement actif comprend de l'antimoine (Sb).

11. Générateur thermoélectrique, en particulier pour véhicule automobile,
avec au moins un dispositif thermoélectrique (1) selon l'une quelconque des revendications précédentes.

12. Véhicule automobile avec au moins une unité d'alimentation en énergie, en particulier une batterie rechargeable, et un générateur thermoélectrique selon la revendication 11.

13. Procédé de fabrication d'un dispositif thermoélectrique (1), en particulier selon l'une quelconque des revendications 1 à 10,
comprenant les étapes suivantes consistant à :
a) fournir au moins deux éléments thermoélectriques (2, 2a, 2b, 2c) d'un matériau thermoélectriquement actif,
b) appliquer une couche d'adaptateur (7, 8) en métal sur les deux éléments thermoélectriques (2, 2a, 2b, 2c),
c) appliquer un élément de piste conductrice (4, 4ab, 4ac) sur les couches d'adaptateur (7, 8) de manière à connecter électriquement les éléments thermoélectriques (2, 2a, 2b, 2c),
**caractérisé en ce que**
le procédé comprend l'étape a1) suivant en aval de l'étape a)
a1) rendre rugueuse la surface du matériau thermoélectriquement actif des éléments thermoélectriques (2, 2a, 2b, 2c) au moyen d'un procédé de meulage.

14. Procédé selon la revendication 13,
**caractérisé en ce que**
l'application selon l'étape b) survient au moyen d'un procédé de pulvérisation, en particulier au moyen d'une pulvérisation de fil ou au moyen d'une pulvérisation par gaz froid.
